(19) Europäisches Patentamt
European Patent Office
Office européen des brevets

(11) EP 2 240 547 B1

(12) **EUROPEAN PATENT SPECIFICATION**

(45) Date of publication and mention of the grant of the patent:
**07.08.2013 Bulletin 2013/32**

(21) Application number: **08872129.5**

(22) Date of filing: **12.12.2008**

(51) Int Cl.:
***C09G 1/02*** *(2006.01)* ***C09K 3/14*** *(2006.01)*
***H01L 21/306*** *(2006.01)* ***H01L 21/3105*** *(2006.01)*

(86) International application number:
**PCT/EP2008/067422**

(87) International publication number:
**WO 2009/097937 (13.08.2009 Gazette 2009/33)**

(54) **PROCESS FOR POLISHING A SILICON SURFACE BY MEANS OF A CERIUM OXIDE-CONTAINING DISPERSION**

VERFAHREN ZUM POLIEREN EINER SILICIUMFLÄCHE ANHAND EINER CEROXIDHALTIGEN DISPERSION

PROCÉDÉ DE POLISSAGE D'UNE SURFACE DE SILICIUM AU MOYEN D'UNE DISPERSION CONTENANT DE L'OXYDE DE CÉRIUM

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **08.02.2008 DE 102008008184**

(43) Date of publication of application:
**20.10.2010 Bulletin 2010/42**

(73) Proprietor: **Evonik Degussa GmbH**
**45128 Essen (DE)**

(72) Inventors:
- **KRÖLL, Michael**
  **63589 Linsengericht (DE)**
- **KRÄMER, Michael**
  **61137 Schöneck (DE)**
- **ZWICKER, Gerfried**
  **25524 Itzehoe (DE)**
- **TORKLER, Michael**
  **25524 Itzehoe (DE)**

(56) References cited:
**EP-A- 1 757 560**
**WO-A-02/096999**
**WO-A-2008/101553**
**JP-A- 2006 205 265**
**US-A1- 2006 213 126**
**US-A1- 2007 199 477**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 240 547 B1

## Description

The invention relates to a process for polishing silicon surfaces by means of a dispersion which comprises cerium oxide particles, a polymeric, anionic dispersing additive and an oxidizing agent.

For the production of silicon wafers for use in microelectronics, typically three polishing steps are carried out:

1. The "stock removal" step after sawing, grinding and etching of the silicon wafer, which, for modern 300 mm wafers, is carried out in the form of a double-sided polishing process (DSP). For the removal of the grinding damage in the single crystal and for the achievement of a good wafer geometry (plane-parallelism), approx. 20 μm (10 μm per side) are removed. The dispersions used are based generally on colloidal silica. To achieve a higher removal rate, a high pH, approx. 11.5-12, is employed. To prevent partial etching of the silicon, the pH is lowered with a stop dispersion after the polishing process has ended. This is followed by hydrophilization, i.e. saturation of the silicon surface with OH groups or oxygen atoms. Only hydrophilized surfaces can be cleaned sufficiently well.

2. The "final polish" step. It ensures a defined smooth frontside of the polished wafer (which has been polished on both sides) and ensures, among other things, the removal of scratches or handling traces after DSP and wafer edge grinding/polishing. About 500 nm - 1 μm are removed. Generally similar dispersions to those in the first step are used.

3. The "haze-free" polishing step. A particularly gentle polishing step once again removes a few tens of nanometres of silicon in order to obtain the wafer frontside smooth to angstrom level, which is required for chip production. This smooth surface is required in order to produce the extremely thin gate oxides which are obtained by thermal oxidation in homogeneous thickness. Local peaks in the silicon would lead to locally increased field strengths at these points and hence to possible electrical breakdowns of the insulator. For the "haze-free" step, very pure colloidal silica dispersions with very soft abrasive particles at a pH of about 10 or lower with a solids content of about 0.5% are used. For good cleaning after the polishing and a clean wafer surface, the wafers have to leave the polisher in hydrophilized form, and so, in many cases, additional hydrophilizing baths have to be used.

JP2006205265 discloses a method of polishing a silicon wafer comprising a slurry having a pH of 10-11.5, comprising a silicon oxide abrasive, a carbonate ion and a dispersant.

It was an object of the present invention to provide a process for polishing silicon surfaces, especially silicon wafers, in which costly and inconvenient stop and hydrophilizing baths can be dispensed with.

The invention provides a process for polishing silicon surfaces, characterized in that a dispersion which comprises cerium oxide particles, at least one polymeric, anionic dispersing additive and at least one oxidizing agent and which has a pH of 7.5 to 10.5 is used,

- said cerium oxide particles having a positive charge and
- polymeric, anionic dispersing additive and oxidizing agent being soluble in the liquid phase of the dispersion.

The positive charge of the cerium oxide particles can be determined via the zeta potential. The zeta potential is a measure for the surface charge of the particles, which can be shifted by polymeric, anionic dispersing additives which accumulate at the surface. The zeta potential is understood to mean the potential at the shear plane within the electrochemical cerium oxide particle/electrolyte double layer in the dispersion. An important parameter in connection with the zeta potential is the isoelectric point (IEP) for a particle. The IEP indicates the pH at which the zeta potential is zero.

The zeta potential of the cerium oxide particles is determined in the pH range of 7.5-10.5 by means of the electrokinetic sound amplitude. To this end, a dispersion which comprises 1% by weight of cerium oxide with water as the liquid phase is prepared. The dispersion is effected with an ultrasound rod (400 W). The dispersion is stirred with a magnetic stirrer and pumped by means of a peristaltic pump through the PPL-80 sensor of the ESA-8000 instrument from Matec. The potentiometric titration with 5M NaOH to pH 10.5 starts from the starting pH. The back-titration to pH 7.5 is undertaken with 5M $HNO_3$. The evaluation is effected according to

$$\zeta = \frac{ESA \cdot \eta}{\phi \cdot \Delta\rho \cdot c \cdot |G(\alpha)| \cdot \varepsilon \cdot \varepsilon_r}$$

where
ESA = electrokinetic sound amplitude,
$\zeta$ = zeta potential,
$\phi$ = volume fraction,

$\Delta\rho$ = density difference between particles and liquid,
c = speed of sound in the suspension,
$\eta$ = viscosity of the liquid,
$\varepsilon$ = dielectric constant of the suspension,
$|G(\alpha)|$ = correction for inertia.

The zeta potential of the cerium oxide particles present in the inventive dispersion is preferably +20 to +60 mV, more preferably +30 to +40 mV.

The mean particle diameter of the cerium oxide particles in the inventive dispersion is not more than 200 nm. Preference is given to a range of 20 to 90 nm. In polishing processes, the best results with regard to removal and defect rate are obtained within this range. The cerium oxide particles may be present in the form of isolated individual particles or else in the form of aggregated primary particles.

The mean particle diameter, in the case of aggregated primary particles the mean aggregate diameter, is preferably less than 200 nm. Particular preference may be given to a range of 50 to 150 nm. The value can be determined, for example, by means of dynamic light scattering.

The proportion of cerium oxide in the inventive dispersion may vary over a wide range. The content of cerium oxide may preferably be 0.01 to 50% by weight, based on the dispersion. High proportions are desired when the intention is, for example, to minimize transport costs. In the case of use as a polishing agent, the proportion of cerium oxide is preferably 0.01 to 5% by weight and more preferably 0.1 to 1% by weight, based on the dispersion.

The cerium oxide particles used preferably have a BET surface area of 30 to 100 $m^2/g$ and more preferably of 40-80 $m^2/g$.

The proportion of sodium is generally not more than 5 ppm and that of chlorine not more than 20 ppm. The elements mentioned are generally tolerable only in small amounts in chemomechanical polishing.

The cerium oxide particles may be present as isolated individual particles or else in the form of aggregated primary particles. The inventive dispersion preferably comprises aggregated cerium oxide particles, or the cerium oxide particles are present predominantly or completely in aggregated form.

It has been found to be advantageous to use cerium oxide particles which have an isoelectric point (IEP) at pH values of 9 to 11. This allows the preparation of stable dispersions in the pH range of 7 to 8.5. The IEP indicates the pH at which the zeta potential is zero. The greater the zeta potential, the more stable the dispersion is. The zeta potential can be determined, for example, by measuring the colloidal vibration current (CVI) of the dispersion or by determining the electrophoretic mobility. In addition, the zeta potential can be determined by means of the electrokinetic sound amplitude (ESA).

Particularly suitable cerium oxide particles have been found to be those which contain carbonate groups on their surface and in layers close to the surface. Especially those as disclosed in DE-A-102005038136. These are cerium oxide particles which

- have a BET surface area of 25 to 150 $m^2/g$,
- the primary particles have a mean diameter of 5 to 50 nm,
- the layer of the primary particles close to the surface has a depth of approx. 5 nm,
- in the layer close to the surface, the carbonate concentration, proceeding from the surface at which the carbonate concentration is at its highest, decreases toward the interior,
- the carbon content on the surface which stems from the carbonate groups is 5 to 50 area per cent and, in the layer close to the surface, is 0 to 30 area per cent in a depth of approx. 5 nm
- the content of cerium oxide, calculated as $CeO_2$ and based on the powder, is at least 99.5% by weight and
- the content of carbon, comprising organic and inorganic carbon, is from 0.01 to 0.3% by weight, based on the powder.

The carbonate groups can be detected both at the surface and in a depth up to approx. 5 nm of the cerium oxide particles. The carbonate groups are chemically bonded and may, for example, be arranged as in the structures a-c.

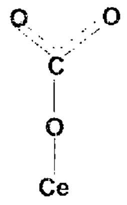 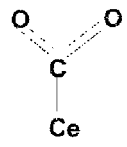 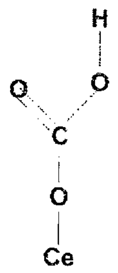

a b c

The carbonate groups can be detected, for example, by XPS/ESCA analysis. To detect the carbonate groups in the layer close to the surface, some of the surface can be ablated by means of argon ion bombardment, and the new surface which arises can likewise be analysed by means of XPS/ESCA (XPS = X-ray Photoelectron Spectroscopy; ESCA = Electron Spectroscopy for Chemical Analysis).

The dispersion used in the process according to the invention comprises, in addition to cerium oxide particles, also one or more polymeric, anionic dispersing additives. In this context, "anionic" is understood to mean that the dispersing additive possesses one or more negatively charged functional groups and is formed from a polar moiety and nonpolar moiety. The negatively charged functional group may, for example, be a carboxylate group, a sulphonate group or a sulphate group.

These additives are preferably selected from the group comprising acrylic acid polymers, methacrylic acid polymers, ammonium laurylsulphate and polyoxyethylene lauryl ether ammonium sulphate.

Particular preference is given to polyacrylic acids and/or salts thereof, especially ammonium polyacrylates. The mean (number-average) molecular weight may preferably be 500 to 50 000, particular preference being given to a range of 1000 to 30 000.

The proportion of the polymeric, anionic dispersing additives is preferably 0.1 to 20% by weight, based on cerium oxide.

The dispersion used in the process according to the invention comprises, as well as cerium oxide particles and polymeric, anionic dispersing additive, one or more oxidizing agents, generally with a content of 0.1-20% by weight, based on the dispersion. For this purpose, it is possible to use hydrogen peroxide, a hydrogen peroxide adduct, for example the urea adduct, an organic peracid, an inorganic peracid, an imino peracid, a persulphate, perborate, percarbonate, oxidizing metal salts and/or mixtures of the above. More preferably, hydrogen peroxide can be used. Owing to the reduced stability of some oxidizing agents with respect to other constituents of the inventive dispersion, it may be advisable not to add them until immediately before the use of the dispersion.

The liquid phase of the inventive dispersion comprises water, organic solvents and mixtures of water with organic solvents. In general, the main constituent with a proportion of >90% by weight of liquid phase is water.

The inventive dispersion may further comprise oxidation activators. Suitable oxidation activators may be the metal salts of Ag, Co, Cr, Cu, Fe, Mo, Mn, Ni, Os, Pd, Ru, Sn, Ti, V and mixtures thereof. Additionally suitable are carboxylic acids, nitriles, ureas, amides and esters. Particular preference may be given to iron(II) nitrate. The concentration of the oxidation catalyst may, depending on the oxidizing agent and the polishing task, be varied within a range between 0.001 and 2% by weight. Particular preference may be given to the range between 0.01 and 0.05% by weight.

The corrosion inhibitors, which are generally present in the inventive dispersion with a proportion of 0.001 to 2% by weight, may be nitrogen-containing heterocycles such as benzotriazole, substituted benzimidazoles, substituted pyrazines, substituted pyrazoles and mixtures thereof.

In addition, the dispersion used may also comprise acids, bases, salts. The pH can be adjusted by means of acids or bases. The acids used may be inorganic acids, organic acids or mixtures. The inorganic acids used may especially be phosphoric acid, phosphorous acid, nitric acid, sulphuric acid, mixtures thereof, and the acidic salts thereof. The organic acids used are preferably carboxylic acids of the general formula $C_nH_{2n+1}CO_2H$ where n = 0-6 or n=8, 10, 12, 14, 16, or dicarboxylic acids of the general formula $HO_2C(CH_2)_nCO_2H$ where n = 0-4, or hydroxycarboxylic acids of the general formula $R_1R_2C(OH)CO_2H$ where $R_1$ = H, $R_2$ = $CH_3$, $CH_2CO_2H$, $CH(OH)CO_2H$, or phthalic acid or salicylic acid, or acidic salts of the aforementioned acids or mixtures of the aforementioned acids and salts thereof. The pH can be increased by adding ammonia, alkali metal hydroxides, amines or urotropin.

**Examples**

Analysis

The specific surface area is determined to DIN 66131.

The surface properties are determined by large-area (1 $cm^2$) XPS/ESCA analysis (XPS = X-ray photoelectron spectroscopy; ESCA = electron spectroscopy for chemical enalysis). The evaluation is based on the general recommendations according to DIN technical report No. 39, DMA(A)97 of the National Physics Laboratory, Teddington, U.K, and the knowledge to date regarding the development-accompanying standardization of the "Oberflächen- und Mikrobereichsanalysen" [Surface and Microscopic Region Analyses] working committee NMP816(DIN). In addition, the comparative spectra available in each case from the technical literature are considered. The values are calculated by background subtraction, taking account of the relative sensitivity factors of the electron level specified in each case. Data are in area per cent. The accuracy is estimated at a relative +/- 5%.

The mean aggregate diameters are determined with an LB-500 particle size analyser from Horiba.

The surface roughness of the polished samples was determined by means of:

a. a Censor ANS 100 laser surface scanner, by which the wafers were evaluated for scattered light (haze). The laser spot diameter is about 50 μm; the entire wafer was scanned. Information regarding medium- to long-wave unevenness in the range of a few tens of μm is thus supplied. The measurement unit ppm describes the proportion of scattered light in all of the laser light reflected and cannot be assigned directly to any roughness number.

b. a Digital Instruments "Bioscope" Atomic Force Microscope (AFM) in tapping mode, by which the raw data or the processed (smoothed) data for $R_a$ were evaluated. The measurement peak has a radius of curvature in the nm range; the scanned field was 5 x 2.5 μm in size. The very short-wave roughnesses with nm dimensions are detected.

c. a Micromap 512 white light interferometer from ATOS, by which evaluation both for $R_a$ and for peak-valley pv was carried out over the entire measurement field. The size of the measurement field is about 500 x 500 μm; the spatial resolution is 1 μm. The unevenness detected is thus in the medium-wave range (a few μm).

The removal rates were determined gravimetrically.

Feedstocks

Cerium oxide: pyrogenic cerium oxide as described in DE-A-102005038136, Example 2.
Analytical data: BET 60 $m^2$/g, particle diameter 65 nm. $CeO_2$ content 99.79% by weight, C content 0.14% by weight, zeta potential 48 mV at pH=5, IEP at pH=9.8.

Dispersions

D0: The dispersion is obtained by adding cerium oxide powder to water and dispersing it by ultrasound treatment with an ultrasound finger (from Bandelin UW2200/DH13G), level 8, 100%; 5 minutes), and then adjusting the pH to 7.5 with aqueous ammonia. A dispersion comprising 0.5% by weight of cerium oxide is obtained.

D1: The dispersion is obtained by adding cerium oxide powder and polyacrylic acid [mean number-average molecular weight 2000] to water and dispersing them by ultrasound treatment with an ultrasound finger (from Bandelin UW2200/DH13G), level 8, 100%; 5 minutes), and then adjusting the pH to 7.5 with aqueous ammonia. A dispersion comprising 0.5% by weight of cerium oxide and 0.015% by weight of ammonium polyacrylate is obtained.

D1/$H_2O_2$: a sufficient amount of aqueous 30 per cent by weight hydrogen peroxide solution is added to D1 that the content of hydrogen peroxide is 0.5% by weight. The cerium oxide particle size is 78 nm.

D2: Glanzox® 3900 RS, Fujimi; ammonia-stabilized dispersion of colloidal silicon dioxide, $SiO_2$ content 10% by weight, pH 10, diluted with water to 0.5% by weight of $SiO_2$.

D2/$H_2O_2$: A sufficient amount of aqueous 30 per cent hydrogen peroxide solution is added to D2 that the content of hydrogen peroxide is 0.5% by weight. The silicon dioxide particle size is 32-38 nm.

Wafers:

Untreated: smooth 150 mm monitor wafer.

The polished wafers were cleaned by the integrated brush cleaning system with PVA sponge brushes (PVA = polyvinyl alcohol) in water.

All polishing tests were carried out on a Peter Wolters PM 200 CMP Clustertool. The haze-free polishing step was effected on the touch-up plate of the system using an SPM 3100 pad from Rohm & Haas (industry standard). The process data were

| | |
|---|---|
| downforce | 400 N |
| chuck speed | 49 rpm |
| touch-up plate speed | 50 rpm |
| slurry flow | 400 ml/min |
| polishing time | 1 min |

**Table 1: Polishing results**

| | | | Comparative examples | | | | According to invention |
|---|---|---|---|---|---|---|---|
| | | | **1** | **2** | **3** | **4** | **5** |
| **Haze-free polishing with** | | | D0 | D2 | D1 | D2/$H_2O_2$ | D1/$H_2O_2$ |
| **Removal rate[a)]** | | nm/ min | - | 20 | 14.2 | 19.5 | 31.5 |
| **Haze** | | ppm | 0.065 | 0.059 | 0.164 | 0.128 | 0.089 |
| **$R_a$ AFM** | b) | A | 1.19 | 1.23 | 1.14 | 1.17 | 0.99 |
| | c) | A | 1.19 | 1.23 | 1.13 | 1.16 | 0.99 |
| **Interferometer** | $R_a$ | A | 3.6 | 5.5 | 6.4 | 5.1 | 4.2 |
| | p-v | A | 44 | 47 | 68 | 47 | 47 |
| a) (± 2 nm/min); b) uncleaned; c) cleaned | | | | | | | |

Table 1 shows the results of the polishing tests. It is found that a significantly higher removal rate is achieved for D1/$H_2O_2$. The addition of hydrogen peroxide brings about a doubling of the removal rate compared to D1, in which no hydrogen peroxide is used.

It is additionally found that the haze value for D1/$H_2O_2$ is somewhat higher than for D1. However, it is only slightly (0.089) above the value for the wafer used (0.065).

The analysis with the AFM, in contrast, gives better roughness values for D1/$H_2O_2$ in comparison to the starting materials, while D2 and D2/$H_2O_2$ give rise to values comparable to the starting wafer.

The evaluation for p-v, which also takes account of significant vertical unevenness, gives values corresponding to the starting wafer for D1/$H_2O_2$.

For D1/$H_2O_2$ the surfaces of the haze-free polished silicon wafers are hydrophilic after polishing.

## Claims

1. Process for polishing silicon surfaces, **characterized in that** a dispersion which comprises cerium oxide particles, at least one polymeric, anionic dispersing additive and at least one oxidizing agent and which has a pH of 7 to 10.5 is used,

   - said cerium oxide particles having a positive charge and
   - polymeric, anionic dispersing additive and oxidizing agent being soluble in the liquid phase of the dispersion.

2. Dispersion according to Claim 1, **characterized in that** the cerium oxide particles have a zeta potential of +20 to +60 mV.

3. Process according to Claim 1 or 2, **characterized in that** a dispersion in which the mean particle diameter of the cerium oxide particles is not more than 200 nm is used.

4. Process according to Claims 1 to 3, **characterized in that** a dispersion with a proportion of cerium oxide of 0.01 to 50% by weight, based on the dispersion, is used.

5. Process according to Claims 1 to 4, **characterized in that** the cerium oxide particles used have a BET surface area of 30 to 100 $m^2/g$.

6. Process according to Claims 1 to 5, **characterized in that** the cerium oxide particles used have a proportion of sodium of not more than 5 ppm and of chlorine of not more than 20 ppm.

7. Process according to Claims 1 to 6, **characterized in that** the cerium oxide particles are present in the form of aggregated primary particles.

8. Process according to Claims 1 to 7, **characterized in that** the cerium oxide particles have an isoelectric point at pH values of 9 to 11.

9. Process according to Claims 1 to 8, **characterized in that** a dispersion which comprises, as the polymeric, anionic dispersing additive, one or more selected from the group comprising acrylic acid polymers, methacrylic acid polymers, and polyoxyethylene lauryl ether ammonium sulphate is used.

10. Process according to Claims 1 to 9, **characterized in that** a dispersion which comprises, as the polymeric, anionic dispersing additive, one or more polyacrylic acids and/or salts thereof is used.

11. Process according to Claims 1 to 10, **characterized in that** the proportion of polymeric, anionic dispersing additive is 0.1 to 20% by weight, based on cerium oxide.

12. Process according to Claims 1 to 11, **characterized in that** a dispersion which comprises hydrogen peroxide as the oxidizing agent is used.

13. Process according to Claims 1 to 12, **characterized in that** the proportion of the oxidizing agent in the dispersion used is 0.1 to 20% by weight.

14. Process according to Claims 1 to 13, **characterized in that** a dispersion which, apart from cerium oxide particles, comprises no further abrasives is used.

15. Process according to Claims 1 to 14, **characterized in that** a dispersion whose main constituent of the liquid phase is water is used.

16. Process according to Claims 1 to 15, **characterized in that** a dispersion which comprises acids, bases, salts, oxidation catalysts and/or corrosion inhibitors is used.

**Patentansprüche**

1. Verfahren zum Polieren von Siliciumoberflächen, **dadurch gekennzeichnet, dass** man eine Dispersion einsetzt, die Ceroxidpartikel, wenigstens ein polymeres, anionisches Dispergieradditiv und wenigstens ein Oxidationsmittel enthält und die einen pH-Wert von 7 bis 10,5 aufweist, wobei

   - die Ceroxidpartikel eine positive Ladung aufweisen und
   - polymeres, anionisches Dispergieradditiv und Oxidationsmittel in der flüssigen Phase der Dispersion löslich sind.

2. Dispersion nach Anspruch 1, **dadurch gekennzeichnet, dass** die Ceroxidpartikel ein Zetapotential von +20 bis

+60 mV aufweisen.

3. Verfahren nach Anspruch 1 oder 2, **dadurch gekennzeichnet, dass** man eine Dispersion einsetzt, in der der mittlere Partikeldurchmesser der Ceroxidpartikel maximal 200 nm ist.

4. Verfahren nach den Ansprüchen 1 bis 3, **dadurch gekennzeichnet, dass** man eine Dispersion mit einem Anteil an Ceroxid von 0,01 bis 50 Gew.-%, bezogen auf die Dispersion, einsetzt.

5. Verfahren nach den Ansprüchen 1 bis 4, **dadurch gekennzeichnet, dass** die eingesetzten Ceroxidpartikel eine BET-Oberfläche von 30 bis 100 $m^2/g$ aufweisen.

6. Verfahren nach den Ansprüchen 1 bis 5, **dadurch gekennzeichnet, dass** die eingesetzten Ceroxidpartikel einen Anteil an Natrium von nicht mehr als 5 ppm und an Chlor von nicht mehr als 20 ppm aufweisen.

7. Verfahren nach den Ansprüchen 1 bis 6, **dadurch gekennzeichnet, dass** die Ceroxidpartikel in Form aggregierter Primärpartikel vorliegen.

8. Verfahren nach den Ansprüchen 1 bis 7, **dadurch gekennzeichnet, dass** die Ceroxidpartikel einen isoelektrischen Punkt bei pH-Werten von 9 bis 11 aufweisen.

9. Verfahren nach den Ansprüchen 1 bis 8, **dadurch gekennzeichnet, dass** man eine Dispersion einsetzt, die als polymeres, anionisches Dispergieradditiv eines oder mehrere ausgewählt aus der Gruppe umfassend Acrylsäurepolymere, Methacrylsäurepolymere und Polyoxyethylenlaurylether-ammoniumsulfat enthält.

10. Verfahren nach den Ansprüchen 1 bis 9, **dadurch gekennzeichnet, dass** man eine Dispersion einsetzt, die als polymeres, anionisches Dispergieradditiv eine oder mehrere Polyacrylsäuren und/oder deren Salze enthält.

11. Verfahren nach den Ansprüchen 1 bis 10, **dadurch gekennzeichnet, dass** der Anteil an polymerem, anionischem Dispergieradditiv 0,1 bis 20 Gew.-%, bezogen auf Ceroxid, beträgt.

12. Verfahren nach den Ansprüchen 1 bis 11, **dadurch gekennzeichnet, dass** man eine Dispersion einsetzt, die als Oxidationsmittel Wasserstoffperoxid enthält.

13. Verfahren nach den Ansprüchen 1 bis 12, **dadurch gekennzeichnet, dass** der Anteil des Oxidationmittels in der eingesetzten Dispersion 0,1 bis 20 Gew.-% beträgt.

14. Verfahren nach den Ansprüchen 1 bis 13, **dadurch gekennzeichnet, dass** man eine Dispersion einsetzt, die außer Ceroxidpartikeln keine weiteren Abrasivstoffe enthält.

15. Verfahren nach den Ansprüchen 1 bis 14, **dadurch gekennzeichnet, dass** man eine Dispersion einsetzt, deren Hauptbestandteil der flüssigen Phase Wasser ist.

16. Verfahren nach den Ansprüchen 1 bis 15, **dadurch gekennzeichnet, dass** man eine Dispersion einsetzt, die Säuren, Basen, Salze, Oxidationskatalysatoren und/oder Korrosionsinhibitoren enthält.

## Revendications

1. Procédé de polissage de surfaces de silicium, **caractérisé en ce qu'**est utilisée une dispersion qui comprend des particules d'oxyde de cérium, au moins un dispersant polymère anionique et au moins un oxydant et qui a un pH de 7 à 10,5,

   - lesdites particules d'oxyde de cérium ayant une charge positive, et
   - le dispersant polymère anionique et l'oxydant étant solubles dans la phase liquide de la dispersion.

2. Dispersion selon la revendication 1, **caractérisée en ce que** les particules d'oxyde de cérium ont un potentiel zêta de +20 à +60 mV.

3. Procédé selon la revendication 1 ou 2, **caractérisé en ce qu'**est utilisée une dispersion dans laquelle le diamètre moyen des particules d'oxyde de cérium ne dépasse pas 200 nm.

4. Procédé selon les revendications 1 à 3, **caractérisé en ce qu'**est utilisée une dispersion avec une proportion d'oxyde de cérium de 0,01 à 50 % en poids de la dispersion.

5. Procédé selon les revendications 1 à 4, **caractérisé en ce que** les particules d'oxyde de cérium utilisées ont une surface spécifique BET de 30 à 100 $m^2/g$.

6. Procédé selon les revendications 1 à 5, **caractérisé en ce que** les particules d'oxyde de cérium utilisées ont une proportion de sodium ne dépassant pas 5 ppm et une proportion de chlore ne dépassant pas 20 ppm.

7. Procédé selon les revendications 1 à 6, **caractérisé en ce que** les particules d'oxyde de cérium sont présentes sous la forme de particules primaires agglomérées.

8. Procédé selon les revendications 1 à 7, **caractérisé en ce que** les particules d'oxyde de cérium présentent un point isoélectrique à des valeurs de pH de 9 à 11.

9. Procédé selon les revendications 1 à 8, **caractérisé en ce qu'**est utilisée une dispersion qui comprend, comme dispersant polymère anionique, un ou plusieurs composés choisis dans le groupe comprenant les polymères d'acide acrylique, les polymères d'acide méthacrylique, et le sulfate d'ammonium d'éther laurylique de polyoxyéthylène.

10. Procédé selon les revendications 1 à 9, **caractérisé en ce qu'**est utilisée une dispersion qui comprend, comme dispersant polymère anionique, un ou plusieurs acides polyacryliques et/ou les sels de ceux-ci.

11. Procédé selon les revendications 1 à 10, **caractérisé en ce que** la proportion de dispersant polymère anionique est de 0,1 à 20 % en poids de l'oxyde de cérium.

12. Procédé selon les revendications 1 à 11, **caractérisé en ce qu'**est utilisée une dispersion qui comprend du peroxyde d'hydrogène comme oxydant.

13. Procédé selon les revendications 1 à 12, **caractérisé en ce que** la proportion de l'oxydant dans la dispersion utilisée est de 0,1 à 20 % en poids.

14. Procédé selon les revendications 1 à 13, **caractérisé en ce qu'**est utilisée une dispersion qui, à part les particules d'oxyde de cérium, ne comprend aucun autre abrasif.

15. Procédé selon les revendications 1 à 14, **caractérisé en ce qu'**est utilisée une dispersion dont le principal constituant de la phase liquide est de l'eau.

16. Procédé selon les revendications 1 à 15, **caractérisé en ce qu'**est utilisée une dispersion qui comprend des acides, des bases, des sels, des catalyseurs d'oxydation et/ou des inhibiteurs de corrosion.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006205265 B
- DE 102005038136 A